# DEMANDE DE BREVET EUROPEEN

(11) **EP 0 948 059 A1**
(43) Date de publication de la demande: **06.10.1999**
(21) Numéro de dépôt: 98102002.7
(22) Date de dépôt: 05.02.1998
(51) Int. Cl.: H01L 31/0203, H01L 21/68

(54) **Moyens de positionnement pour un dispositif microélectronique et appareil de prise de vues muni d'un tel dispositif**

(71) Demandeur: ASULAB S.A., CH-2501 Bienne (CH)
(72) Inventeur: Dinger, Rudolf, 2024 Saint-Aubin (CH); Grupp, Joachim, 2003 Neuchâtel (CH)
(74) Mandataire: Thérond, Gérard Raymond

(57) **Abrégé**

Dispositif microélectronique formé d'une plaque parallélépipédique (10), dans laquelle est réalisé au moins un capteur (11), et portant des ensembles de plots (12, 13, 14) déposés sur l'une des faces (10a) de ladite plaque (10), pour assurer un positionnement relatif du dispositif avec un organe complémentaire (20), dans lequel ladite face(10a) définit un plan, dans lequel lesdits moyens de positionnement (12, 13, 14) comportent un premier ensemble (12) pour assurer ledit positionnement selon un premier axe parallèle audit plan, un deuxième ensemble (13) pour assurer ledit positionnement selon un deuxième axe également parallèle audit plan et perpendiculaire au premier axe et un troisième ensemble (14)pour définir ladite position selon un troisième axe, perpendiculaire audit plan.

Appareil de prise de vues dans lequel les ensembles de plots permettent de positionner un réseau de microlentilles au-dessus d'un réseau de cellules photoélectriques.

## Description

La présente invention concerne un dispositif microélectronique comportant une plaque munie d'au moins un capteur et des moyens de butée s'étendant à partir d'une face de la plaque, pour positionner un organe complémentaire au dispositif.

On connaît déjà des dispositifs permettant un positionnement précis l'un par rapport à l'autre de deux éléments complémentaires. La demande de brevet EP 0 566 943 décrit par exemple un dispositif microélectronique comportant une plaque pourvue d'une région électriquement active munie d'un axe sensible et de moyens de butée. Dans l'exemple donné, la région électriquement active est aménagée de manière à jouer un rôle d'accéléromètre. Les moyens de butée sont formés de plots déposés sur l'une des faces de ladite plaque. Ils permettent de positionner le capteur, de manière à maîtriser son orientation par rapport à un support formant l'élément complémentaire.

Une telle solution permet d'orienter efficacement un dispositif microélectronique, évitant ainsi un alignement par des moyens optiques sophistiqués.

Dans le dispositif tel que décrit, l'orientation n'est définie que pour une direction, correspondant à l'axe de mesure de l'accéléromètre. Cette direction se trouve dans un plan passant par la face sur laquelle les plots sont déposés. L'orientation est assurée en appuyant au moins deux plots contre une surface de l'élément support aménagée à cet effet.

Il existe des applications qui nécessitent non seulement une orientation relative d'un dispositif microélectronique et de son support, mais aussi un positionnement précis du dispositif microélectronique et d'un organe complémentaire qui lui est associé. La solution mentionnée ci-dessus ne peut assurer un tel positionnement. La présente invention a pour but principal d'apporter une solution à ce problème.

A cet effet, la présente invention a pour objet un dispositif microélectronique formé d'une plaque parallélépipédique, dans laquelle est réalisé au moins un capteur, et portant des moyens de positionnement formés de plots déposés sur l'une des faces de ladite plaque, pour assurer un positionnement relatif du dispositif avec un organe complémentaire, dans lequel ladite face définit un plan, caractérisé en ce que lesdits moyens de positionnement comportent un premier ensemble pour assurer ledit positionnement selon un premier axe parallèle audit plan, un deuxième ensemble pour assurer ledit positionnement selon un deuxième axe également parallèle audit plan et perpendiculaire au premier axe et un troisième ensemble pour définir ladite position selon un troisième axe, perpendiculaire audit plan.

Grâce à ces caractéristiques, il est possible de positionner de manière précise et efficace un dispositif microélectronique avec un organe qui lui est associé.

La présente invention se rapporte également à un appareil de prise de vues dans lequel un objectif doit focaliser de façon très précise la lumière sur un ensemble de capteurs photoélectriques réalisés sur une plaque en matériau semi-conducteur.

L'évolution des techniques de fabrication des circuits intégrés a permis de réduire considérablement les dimensions des capteurs. Pour obtenir la même qualité optique, il est donc nécessaire que l'objectif et les capteurs aient une position relative très précise. Il est plus particulièrement nécessaire que l'axe de l'objectif soit parfaitement perpendiculaire à la surface des capteurs. Ce but pourrait être atteint en faisant appel à des appareils nécessitant de grands grossissements et utilisant des micromanipulateurs. Le coût de telles opérations est élevé, ce qui augmente d'autant le prix de ces appareils.

Le problème se pose avec particulièrement d'acuité lorsque l'objectif comporte un réseau de microlentilles placé à l'avant des capteurs. Un tel réseau est utilisé pour concentrer la lumière sur la partie active des capteurs. En effet, chacun de ceux-ci doit être associé à des composants électroniques pour traiter les informations, ainsi qu'à des conducteurs pour transmettre ces dernières au circuit de commande de l'appareil. En concentrant la lumière du faisceau incident sur chacune des cellules, il est possible de placer, dans leur voisinage immédiat, au moins certains des composants électroniques permettant d'assurer le traitement des informations saisies, sans pour autant réduire la quantité de lumière arrivant sur chaque cellule.

Pour résoudre ce problème, il a été proposé de fabriquer les microlentilles dans une couche de matériau transparent déposée directement sur le réseau de capteurs. Un dispositif de ce type est décrit dans la demande de brevet EP 0 619 614. Cette solution permet effectivement de garantir un excellent positionnement relatif. Malheureusement, la fabrication des microlentilles peut affecter la qualité des capteurs, à cause notamment des traitements thermiques et chimiques que doit subir l'ensemble ainsi constitué, lors de la fabrication des microlentilles. Cela limite en outre les matériaux susceptibles d'être utilisés pour former ce réseau de microlentilles. Le taux de déchets est par ailleurs important.

La présente invention a donc aussi pour but de permettre la réalisation d'un appareil de prise de vues dans lequel un réseau de microlentilles peut être rapporté sur un capteur formé d'un réseau de cellules photoélectriques en assurant un positionnement relatif précis, par des moyens simples et efficaces.

A cet effet, la présente invention a également pour objet un appareil de prise de vue, comportant un dispositif tel que défini ci-dessus, caractérisé en ce que ledit capteur est de type photoélectrique et en ce qu'il comporte un objectif formant ledit organe et comportant au moins un réseau de microlentilles, placé à l'avant de ladite face et destiné à focaliser la lumière sur lesdits capteurs, pour les activer.

D'autres avantages et caractéristiques de l'invention apparaîtront à la lecture de la description détaillée suivante d'un exemple de réalisation donné à titre illustratif et non limitatif en référence aux dessins annexés dans lesquels :
- la figure 1 représente un appareil de prise de vue dont le boîtier est celui d'une montre-bracelet;
- la figure 2 représente en coupe selon la ligne II-II de la figure 1 limité à l'objectif le dispositif de positionnement selon l'invention;
- la figure 3 représente en perspective un dispositif comportant un capteur réalisé au moyen d'un réseau de cellules photoélectriques et portant une lame dans laquelle est ménagé un réseau de microlentilles; et
- la figure 4 représente en coupe selon la ligne IV-IV, une partie de l'ensemble de la figure 3.

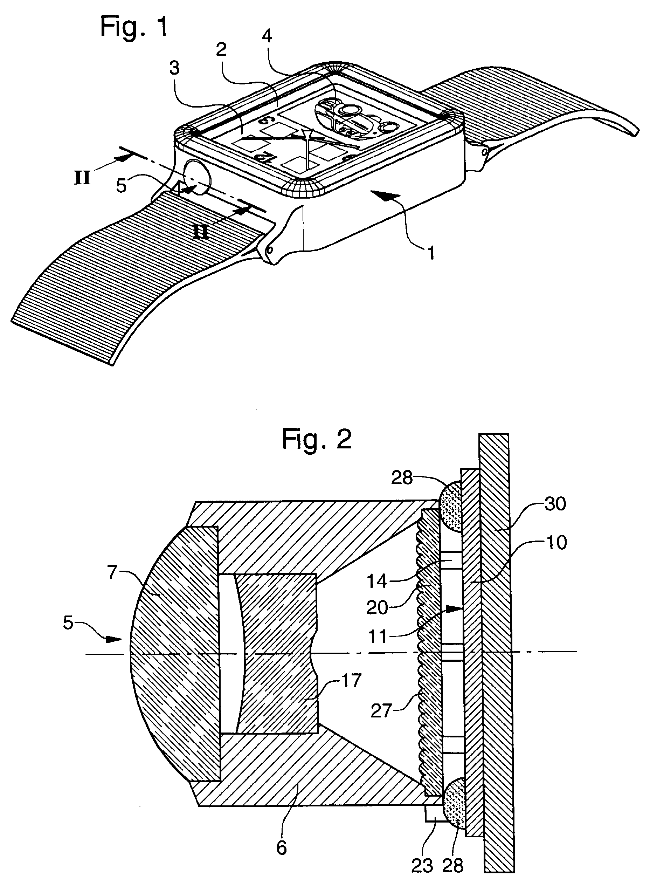

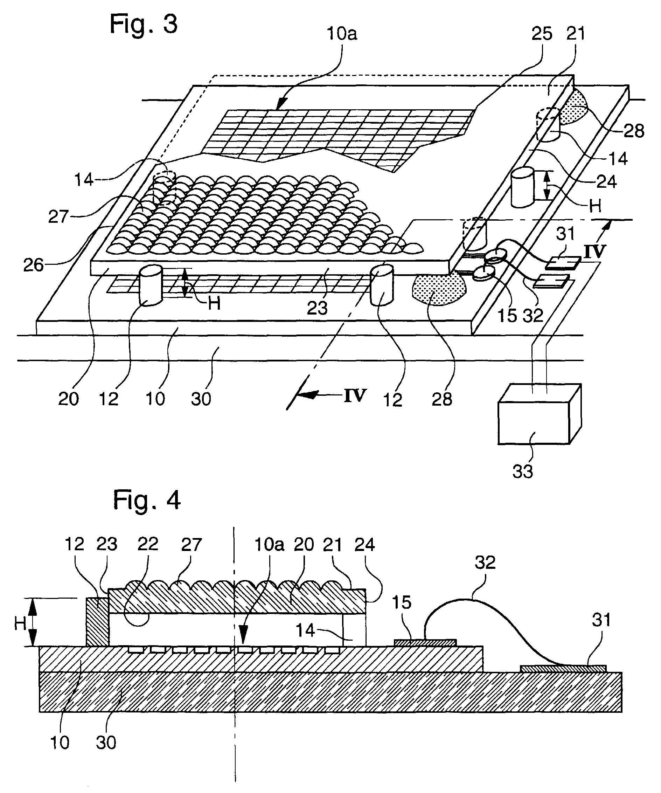

L'appareil de prise de vue représenté à la figure 1 est un appareil miniature de type digital incorporé dans la boîte 1 d'une montre-bracelet de type traditionnel, fermée à sa partie supérieure par une glace 2 disposée au-dessus d'un cadran 3 permettant l'affichage de l'heure et pouvant comporter des moyens de visée par exemple formés par une cellule d'affichage matriciel 4. L'appareil dispose de moyens d'armement/déclenchement, non visibles sur la figure 1, positionnés par exemple près de la couronne du remontoir. L'appareil possède enfin un objectif 5, disposé sur le pourtour de la boîte 1 sensiblement entre les positions 11 h et 3 h. Cet objectif représenté en coupe à la figure 2 comprend un châssis 6 permettant de positionner axialement une lentille frontale 7, une lentille intermédiaire 17 et un élément optique postérieur composé d'un réseau de microlentilles 27 formé dans une lame transparente 20. Cet objectif est positionné de façon très précise selon trois axes au-dessus d'une plaque 10 en un matériau semi-conducteur dans lequel est formé un réseau matriciel 11 de cellules photoélectriques formant capteur, ladite plaque 10 étant solidaire de la boîte 1 de l'appareil au moyen du support 30. Le positionnement précis de cet objectif 5 par rapport au réseau de capteurs 11 est obtenu grâce à des ensembles de plots de positionnement 12, 13 et 14, décrits ci-après plus en détail en référence également aux figures 3 et 4.

L'ensemble représenté aux figures 2, 3 et 4 comprend une plaque 10, une lame transparente 20 et un support 30.

La plaque 10 est en matériau semi-conducteur, dont la partie centrale de l'une des faces comporte un réseau matriciel 11 de cellules photoélectriques. Cette face porte en outre quatre ensembles de plots, portant respectivement les références 12, 13, 14 et 15. Des pistes conductrices 16 et des composants électroniques (non représentés) permettent respectivement de conduire et de traiter les informations provenant des cellules photoélectriques.

Les plots des ensembles portant les références 12, 13 et 14 sont destinés à positionner la lame 20. Ainsi que cela sera précisé ci-après, les plots de l'ensemble 15 servent de bornes de liaison pour relier électriquement des pistes conductrices de la plaque 10 et du support 30. Aussi bien les plots des ensembles 12, 13 et 14 que les plots de l'ensemble 15 sont déposés par des techniques d'électro-déposition connues, faisant appel à des masques. Ils sont avantageusement recouverts d'or et désignés de façon usuelle par le terme "bump" en microélectronique.

Le premier ensemble 12 et le deuxième ensemble 13 sont formés respectivement de deux plots et de un plot ayant tous une même première hauteur H. Le troisième ensemble 14 est formé de trois plots ayant une deuxième hauteur h, plus faible que la hauteur H. Le quatrième ensemble 15 comprend un nombre plus élevé de plots, fonction du nombre de liaisons à assurer entre le réseau 11 de cellules photoélectriques et le support 30. Pour plus de clarté, le dessin de la figure 3, seuls deux plots ont été représentés. La hauteur des plots de ce quatrième ensemble peut être égale à celle des plots du troisième ensemble.

La lame transparente 20, de forme générale parallélépipédique, est réalisée en un matériau choisi pour ses caractéristiques optiques. Elle peut par exemple être faite en PMMA (polymethyl-metha-acrylate), par moulage. La lame 20 comprend une face supérieure 21, une face inférieure 22 et quatre faces latérales portant les références 23 à 26. Un réseau matriciel 27 de microlentilles convergentes, ayant au moins autant de lignes et autant de colonnes que le réseau 11, est ménagé sur la face supérieure 21. Le pas des lignes et des colonnes est le même pour l'un et l'autre des réseaux.

Le support 30 porte la plaque 10 ainsi que d'autres composants électriques non représentés au dessin. Il comporte des pistes conductrices 31. Ces pistes sont reliées aux plots de l'ensemble 15 au moyen de fils 32, chacun étant soudé par l'une de ses extrémités sur un plot de l'ensemble 15 et par l'autre extrémité sur une piste conductrice 31 permettant de transférer les signaux issus du capteur vers un circuit électronique de traitement 33 permettant notamment d'effectuer la visée et de mémoriser les images retenues.

Des points de colle 28, servant d'adhésif, sont placés à la périphérie de la lame 20. Ils assurent la fixation de celle-ci sur la plaque 10. Ces points 28 sont avantageusement disposés aux quatre coins de la lame 20.

En variante, une couche adhésive, non représentée au dessin, pourrait assurer la liaison entre la plaque 10 et la lame 20, tout en participant, à cause de ses caractéristiques optiques, au traitement du faisceau lumineux.

Comme cela a été dit plus haut, les plots des trois premiers ensembles assurent le positionnement de la lame 20. Plus précisément, la lame 20 repose par sa face inférieure 22 sur les trois plots du troisième ensemble 14. Elle est appuyée par les extrémités de sa face 23 contre les deux plots du premier ensemble 12 et par le milieu de la face 24, orthogonale aux faces 21 et 22, contre le plot du deuxième ensemble 13.

En raison de cette configuration particulière, la lame 20 est parfaitement orientée par rapport à la plaque 10, garantissant ainsi le positionnement de chacune des lentilles du réseau matriciel 27 en regard d'une cellule du réseau matriciel 11, tout en évitant des opérations susceptibles d'affecter la qualité des capteurs.

Dans l'exemple qui vient d'être décrit le nombre de plots des premier, deuxième et troisième ensembles a été réduit au minimum, mais l'homme de métier peut, sans sortir du cadre de l'invention concevoir un dispositif contenant un plus grand nombre de plots dans chaque ensemble.

## Revendications

1. Dispositif microélectronique formé d'une plaque parallélépipédique (10), dans laquelle est réalisé au moins un capteur (11), et portant des moyens de positionnement (12, 13, 14) formés de plots déposés sur l'une des faces (10a) de ladite plaque (10), pour assurer un positionnement relatif du dispositif avec un organe complémentaire (20), dans lequel ladite face(10a) définit un plan, caractérisé en ce que lesdits moyens de positionnement (12, 13, 14) comportent un premier ensemble (12) pour assurer ledit positionnement selon un premier axe parallèle audit plan, un deuxième ensemble (13) pour assurer ledit positionnement selon un deuxième axe également parallèle audit plan et perpendiculaire au premier axe et un troisième ensemble (14)pour définir ladite position selon un troisième axe, perpendiculaire audit plan.

2. Dispositif selon la revendication 1, caractérisé en ce que les plots formant ledit troisième ensemble (14) ont une hauteur (h) inférieure à la hauteur (H) des plots formant ledit premier ensemble (12) et ledit deuxième ensemble (13).

3. Dispositif selon la revendication 2, caractérisé en ce que les plots formant ledit premier ensemble (12) et ledit deuxième ensemble (13) ont une même hauteur (H).

4. Dispositif selon l'une des revendications 1 à 3, caractérisé en ce qu'il comporte en outre un quatrième ensemble (15) de plots permettant de relier électriquement ledit capteur à un circuit électronique de traitement des signaux (33).

5. Dispositif selon l'une des revendications 1 à 4, destiné à coopérer avec un organe (20) de forme parallélépipédique avec trois faces (22, 23, 24) orthogonales entre elles, dans lequel chacune des faces coopère avec l'un desdits ensembles (12, 13, 14), caractérisé en ce que le premier ensemble (12) comporte deux plots, agencés de manière que ledit organe puisse prendre appui sur le côté desdits plots, par chacune des extrémités de l'une (23) de ses faces.

6. Dispositif selon la revendication 5, caractérisé en ce que le deuxième ensemble (13) comporte un plot, agencé de manière que ledit organe puisse prendre appui sur le côté dudit plot, par le milieu d'une deuxième face (24), orthogonale à la première (23).

7. Dispositif selon la revendication 6, caractérisé en ce que le troisième ensemble (14) comporte au moins trois plots, agencés de manière que ledit organe puisse prendre appui par une troisième de ses faces (22), orthogonale à la première (23) et à la deuxième (24) desdites faces, sur l'extrémité desdits plots.

8. Appareil de prise de vue, comportant un dispositif selon l'une des revendications 1 à 7, caractérisé en ce que ledit capteur est formé d'un réseau (11) de cellules photoélectriques et en ce que ledit organe complémentaire est un objectif comprenant au moins un réseau (27)de microlentilles, placé à l'avant de ladite face et destiné à focaliser la lumière sur lesdites cellules, pour les activer.

9. Appareil de prise de vue selon la revendication 8, caractérisé en ce que ledit réseau (27) de microlentilles est ménagé dans une lame (20) en matériau transparent, de forme générale parallélipipédique, avec une face supérieure (21) présentant une structure en réseau définissant ledit réseau (27) de microlentilles, une face inférieure (22) plane prenant appui sur ledit troisième ensemble (14), une première face latérale (23) prenant appui contre ledit premier ensemble (12) et une deuxième face latérale (24), orthogonale à la première face latérale (23) et prenant appui contre ledit deuxième ensemble (13).

10. Appareil de prise de vues selon la revendication 9, caractérisé en ce que ladite lame (20) est fixée rigidement à ladite plaque (10) au moyen d'un adhésif (28) reliant au moins localement la ladite lame (20) et ladite plaque (10) dans leur périphérie.

11. Appareil de prise de vues selon la revendication 8 ou 9, caractérisé en ce que ladite plaque (10) est fixée à ladite lame (20) au moyen d'une couche de matériau transparent, intercalée entre elles.
